# EUROPEAN PATENT SPECIFICATION

(11) **EP 3 404 712 B1**
(45) Date of publication and mention of the grant of the patent: **28.07.2021**
(21) Application number: 18171004.7
(22) Date of filing: 07.05.2018
(51) Int. Cl.: H01L 23/473, H05K 7/20

(54) **LIQUID COLD PLATE HEAT EXCHANGER**
FLÜSSIGKEITSKÜHLPLATTENWÄRMETAUSCHER
ÉCHANGEUR THERMIQUE À PLAQUE FROIDE À LIQUIDE

(30) Priority: 08.05.2017 CN 201720502689 U
(43) Date of publication of application: 21.11.2018
(73) Proprietor: Aavid Shenzen Thermal Energy System Co. Ltd., 518109 Shenzhen (CN)
(72) Inventor: Parag, Sonawane, Hadapsar, Pune 411028 Maharashtra (IN); Feng, Bert, GuangDong 518060 (CN)
(74) Representative: Hoffmann Eitle

(56) References cited:
- EP-A2- 0 344 084
- US-A- 5 201 866
- US-A1- 2006 021 747
- US-A1- 2010 326 630
- US-A1- 2012 234 515
- US-A1- 2016 106 003

## Description

### Field of Invention

A liquid cold plate heat exchanger, e.g., for cooling electronics using a circulated flow of cooling fluid. US2006/021747 discloses a liquid cold plate according to the preamble of claim 1.

### Background

With the development of electronic technology, heat dissipation requirements for computer processing devices, e.g., integrated circuits or chips, has increased, requiring ever higher efficiency liquid cold plate heat exchange devices to remove the heat generated by these devices.

Examples of the prior art can be found in documents US 2016/106003 A1 and US 2010/326630 A1. Document US 2016/106003 A1 discloses a heat removal assembly that is to thermally couple with two or more dice of an electronic device. The heat removal assembly may include a bellows to automatically adjust a position of at least one surface of the heat removal assembly relative to another surface of the heat removal assembly. This document represents the closest prior art.

### SUMMARY OF INVENTION

One type of device used to cool electronics or other heat generating devices is a liquid cold plate heat exchanger that thermally couples a heat generating device (such as a computer processor) to a heat sink that includes a plurality of fins. At least a portion of the heat sink may be enclosed in a cavity in which a cooling fluid is circulated so that heat may be transferred from the heat sink to the fluid and removed from the cavity. In one embodiment, a heat sink may be sandwiched between upper and lower plates so that the heat sink is located in a cavity defined by the plates. As an example, the heat sink may be placed on the upper surface of a lower plate or base, and a top plate or cap having a cavity formed in an underside of the cap may be placed over the base so the heat sink is enclosed in the cavity. The base and cap may be secured together to form a liquid-tight seal around the cavity so that cooling fluid can be circulated into the cavity without leaking.

Due to manufacturing tolerances and other difficulties, the heat sink and the cavity must be sized so that the top surface of the heat sink does not contact the portion of the cap at the cavity when the cap is placed over the base. That is, if the heat sink top surface were to contact the cap when the cap is placed over the heat sink and the base, the heat sink may prevent the cap from being positioned properly relative to the base, e.g., in direct contact with the base. This can cause problems, such as preventing proper brazing or other joining of the base and cap together so as to form a liquid-tight seal. To avoid these problems, the heat sink and cavity are made so a gap is present between the top surface of the heat sink and the cap when the cap is properly positioned on the base. However, this gap between the heat sink and the cap can prevent effective heat transfer between the heat sink and the cap. For example, because of the gap, heat cannot be transferred across the gap from the cap to the heat sink by conduction, but instead must transfer through the cooling fluid. This can limit the efficiency of cooling of the heat sink or cap, e.g., if a heat generating device is thermally coupled to the cap.

Embodiments in accordance with aspects of the invention can reduce or eliminate a gap between the heat sink and cap in such structures, reducing thermal resistance and improving efficiency. Alternately or in addition, manufacturing tolerances regarding the cavity size and/or heat sink size may be relaxed, and in some cases thermal resistance and or efficiency may be improved while allowing for relatively high heat joining operations such as vacuum brazing of the base and cap. In some cases, the gap between heat sink top surface and cap may be reduced to 0.1mm or less. According to the invention, a spring plate is provided between the cap and the top surface of the heat sink, e.g., on top of the fins of the heat sink. The spring plate may have a floating top surface that contacts the cap and a bottom surface that contacts the heat sink. The cap may have a location groove in the lower surface of the cap that contacts the floating surface of the spring plate, e.g., to help locate the spring plate relative to the cap. The spring plate bottom surface may have good thermal and/or physical contact with heat sink top surface, according to the invention, the spring spans across a plurality of fins. As a result, the spring plate reduces or eliminates the gap between the cap and the heat sink, and the spring plate may function to transfer heat across the gap between the cap and heat sink top surface by conduction.

According to the invention, a liquid cold plate heat exchanger includes a base having an upper surface, and a heat sink having a plurality of fins arranged on the upper surface of the base. The heat sink is thermally coupled to the base, e.g., so that heat transferred to the base by a heat generating device can be conducted to the heat sink. The plurality of fins of the heat sink defines a top surface of the heat sink, e.g., the heat sink may have a plurality of upstanding plate-shaped fins that extend upwardly from a bottom of the heat sink, are parallel to each other and are spaced apart with a distance between adjacent fins being 0.1 to 2mm (or some other suitable value). A cap having a lower surface is positioned over the upper surface of the base and the heat sink, and a spring plate is positioned between the top surface of the heat sink and the lower surface of the cap. With the cap secured to the base, the spring plate is arranged to exert an upward bias on the lower surface of the cap and a downward bias on the top surface of the heat sink. For example, the spring plate may have an upper portion that contacts the cap and a lower portion that contacts the heat sink, and the spring plate may be resilient so that it can exert a resilient bias on the cap and heat sink. A gap between the top surface of the heat sink and the lower surface of the cap is partially or completely filled by the spring plate, e.g., so that heat may be transferred by conduction by the spring plate between the heat sink and the cap. For example, a distance between lower surface of the cap in the cavity and the top surface of the heat sink may be between 0.1mm and 0.2mm, and the spring plate may partially or completely fill the gap in at least some areas.

In some embodiments, the heat sink may be located in a cavity between the base and the cap, and the cavity may be liquid tight so that a fluid cooling medium may be circulated through the cavity for heat transfer with the heat sink. In some cases, the cap includes a cavity in a portion of the lower surface arranged to receive and contact the spring plate and to receive at least a portion of the heat sink. However, in other embodiments, the base may include a cavity to receive at least a portion of the heat sink and/or the spring plate, and/or both the base and cap may include a cavity to receive the heat sink and/or spring plate. To enclose the heat sink in a liquid tight cavity, the cap and the base may be joined together in an area around the heat sink to enclose the heat sink in the cavity. In one particular embodiment, a portion of the upper surface of the base and a portion of the lower surface of the cap are secured directly together to form a liquid-tight seal around the heat sink. In other embodiments, the cap and base may be secured together by an intervening element, such as a spacer. The cap and base may be secured together in different ways, such as vacuum brazing or other relatively high heat operations. Thus, in some embodiments, the base, heat sink, cap and spring plate are arranged to withstand a temperatures required to secure the lower surface of the cap to the upper surface of the base by vacuum brazing, or can be arranged to withstand a temperature of 500 degrees C for at least 1 hour. In some embodiments, the base, heat sink and/or cap may be made of copper or aluminum, and the spring plate may be made of stainless steel or other elastic material.

In some embodiments, the spring plate includes a heat sink contacting portion that contacts the heat sink top surface and a cap contacting portion that contacts the lower surface of the cap, and the heat sink contacting portion is located below the cap contacting portion. For example, the spring plate may be stamped or otherwise formed of a sheet of metal or other suitable material to form a bend between heat sink contacting and cap contacting portions. The bend may allow the spring plate to exert a resilient bias on the cap and heat sink. In some embodiments, the heat sink contacting portion is located between first and second cap contacting portions located at opposite ends of the spring plate. For example, the spring plate may be formed of a bent metal sheet that forms the heat sink contacting portion and the first and second cap contacting portions, and the heat sink contacting portion may be located in a lower plane positioned below an upper plane in which the first and second cap contacting portions are located. Thus, the spring plate may form a U-type shape or channel-type shape with cap contacting portions extending outwardly from the central U or channel portion. In some embodiments, the spring plate may be formed of a metal sheet having a thickness of 0.1 to 0.2 mm, and the thickness of the plate material may be close in size to a designed gap between the cap and top surface of the heat sink.

In another aspect of the invention, a liquid cold plate heat exchanger includes a base having an upper surface, and a heat sink having a plurality of fins arranged on the upper surface of the base with the plurality of fins defining a top surface of the heat sink. A cap may have a lower surface and a cavity formed in a portion of the lower surface with the cavity positioned over the upper surface of the base and the heat sink, e.g., so the heat sink is at least partially received into the cavity. A spring plate is positioned between the top surface of the heat sink and the lower surface of the cap at the cavity so that when a portion of the lower surface of the cap around the cavity is secured to a portion of the upper surface of the base around the heat sink (e.g., by vacuum brazing), and the spring plate is arranged to exert an upward bias on the lower surface of the cap at the cavity and a downward bias on the top surface of the heat sink.

These and other aspects of the invention will be appreciated from the following description and claims.

### BRIEF DESCRIPTION OF THE DRAWINGS

Aspects of the invention are described with reference to the following drawings in which numerals reference like elements, and wherein:
FIG. 1 shows a side view and partial cross sectional view along the line 1-1 in FIG. 2 of a liquid cold plate in an illustrative embodiment;
FIG. 2 shows an exploded perspective view of the FIG. 1 embodiment;
FIG. 3 shows a bottom perspective view of the cap of the FIG. 1 embodiment;
FIG. 4 shows a side view of the spring plate in the FIG. 1 embodiment; and
FIG. 5 shows a side view of the base and heat sink of the FIG. 1 embodiment.

### DETAILED DESCRIPTION

Aspects of the invention are not limited in application to the details of construction and the arrangement of components set forth in the following description or illustrated in the drawings. Other embodiments may be employed and aspects of the invention may be practiced or be carried out in various ways. Also, aspects and/or different features of embodiments of the invention may be used alone or in any suitable combination with each other. Thus, the phraseology and terminology used herein is for the purpose of description and should not be regarded as limiting.

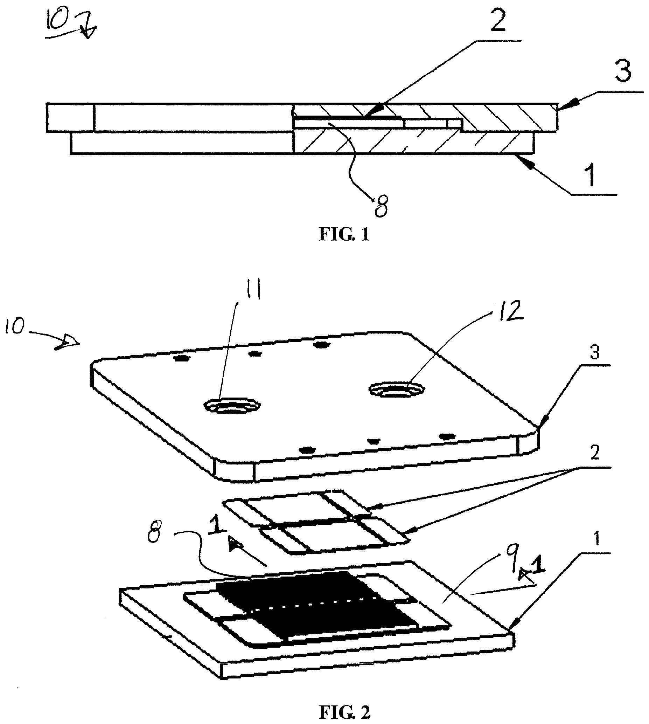

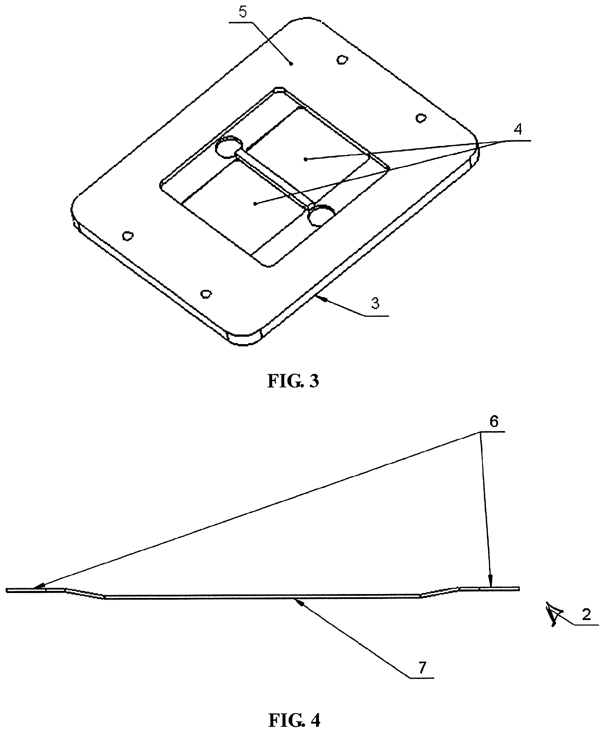

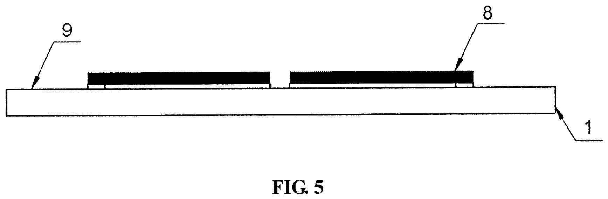

FIGs. 1 and 2 show a liquid cold plate heat exchanger 10 in an illustrative embodiment. The heat exchanger 10 includes a base 1, which may be made of a thermally conductive material such as aluminum or copper or other suitable material. Although not shown, the base 1 may be thermally coupled to a heat generating device, such as a computer processing device or other electronic component, to receive heat from the heat generating device. The base 1 may be thermally coupled to the heat generating device in any suitable way, such as by contacting the heat generating device to a bottom surface of the base 1. One or more heat sinks 8 are positioned on an upper surface 9 of the base 1 as can be seen in FIG. 5. The heat sink 8 may be arranged in any suitable way, e.g., formed of aluminum, copper or other conductive material and having a bottom wall with upstanding plate-like fins extending upwardly from the bottom wall. The heat sink 8 may be thermally coupled to the base 1 to receive heat from the base 1, e.g., the heat sink 8 may be fastened to the base 1 to receive heat by conduction. In some embodiments, the heat sink 8 may be formed unitarily with the base 1, e.g., by forming the base 1 to have a plurality of fins, pins or other elements to function as a heat sink. A cap 3 may be positioned over the heat sink 8 and base 1, e.g., to enclose the heat sink 8 in a cavity. In this embodiment and as can be seen in FIG. 3, the cap 3 may have a cavity 4 formed in a lower surface 5 of the cap 3 to at least partially receive the heat sink 8. Of course, the base 1 may include a cavity to at least partially receive the heat sink 8 rather than the cap 3, or both the cap 3 and base 1 may include a cavity to receive the heat sink 8. As can be seen in FIG. 1, with the cap 3 positioned over the base 1, the heat sink 8 may be enclosed in the cavity 4. In this embodiment, a portion of the lower surface 5 of the cap 3 may be attached to a portion of the upper surface 9 of the base 1 around the heat sink 8 so the heat sink 8 is enclosed in a fluid tight cavity 4. This may allow circulation of a cooling fluid into the cavity 4 for contact with the heat sink 8, e.g., via an inlet port 11 and outlet port 12 in the cap 3. Although the inlet and outlet ports 11, 12 are shown formed in an upper surface of the cap 3, such ports may be provided in any suitable location on the cap 3, base 1 or other portion of the heat exchanger 10. Attachment of the cap 3 and base 1 may be done in any suitable way, and in some embodiments the cap 3 and base 1 are attached by a vacuum brazing process that directly joins the cap 3 lower surface 5 portion with the base 1 upper surface 9 portion. In other cases, the cap 3 and base 1 may be joined by an intervening element, such as a spacer component that defines a cavity 4 in which the heat sink 8 is received and is positioned between the lower surface 5 of the cap 3 and the upper surface 9 of the base 1. This may allow the cap 3 and base 1 to have completely flat lower and upper surfaces, respectively. However, providing the lower surface 5 of the cap 3 with a cavity 4 may allow the cavity 4 to provide a locating function for the heat sink 8.

In accordance with the invention, a spring plate 2 is provided between a top surface of the heat sink 8 and the lower surface of the cap 3. The spring plate 2 provides significant advantages over an arrangement that lacks a spring plate 4 and instead has an open gap between the top surface of the heat sink 8 and the cap 3. For example, an open gap may preclude transfer of heat from the cap 3 to the heat sink 8 by conduction across the gap. In contrast, the spring plate 2 fills at least partially or completely the gap in at least some areas, allowing for thermal conduction across the gap. Also, the spring plate 2 helps relax manufacturing tolerances because the heat sink 8 need not be made with a height that exactly matches the height of the cavity 4. Further, the spring plate 2 exerts a resilient or spring bias downwardly on the heat sink 8 (as well as upwardly on the cap 3) which helps maintain suitable contact between the heat sink 8 and the base 1, e.g., aiding in thermal conduction. In some cases, the gap between the top surface of the heat sink 8, which is defined by a plurality of fins of the heat sink 8, and the lower surface of the cap 3 at the cavity 4 may be 0.1 to 0.2mm, and the spring plate 2 may span this gap, e.g., having a thickness or other dimension of 0.1 to 0.2mm. As an example, the spring plate 2 may be made of a sheet material, such as stainless steel, having a thickness of 0.1 to 0.2 mm. It should be appreciated, however, that the gap between the top surface of the heat sink 8 and the cap 3, as well as the thickness of material used to form the spring plate 2 may be other values, e.g., from 0.1 to 2mm or more. Having the spring plate 2 be made to have a thickness that closely approximates the height of the gap allows the spring plate 2 to at least partially and/or completely fill the gap, aiding in thermal conduction across the gap. In some cases, the spring plate 2 may deform elastically as well as plastically when squeezed between the heat sink 8 and the cap 3. Elastic deformation may allow the spring plate 2 to exert a resilient bias on the cap 3 and heat sink 8, and plastic deformation, e.g., by extrusion, may allow the spring plate 2 to completely fill the gap between the heat sink 8 and cap 3 at least in some areas.

In accordance with aspects of the invention, the spring plate 2 may have an upper portion that contact the cap 3 and a lower portion that contacts the heat sink 8. The upper and lower portions of the spring plate 2 may be joined so that the spring plate 2 can exert a resilient bias on the cap 3 and heat sink 8. For example, FIG. 4 shows a side view of the spring plate 2 that includes a pair of upper portions 6 on opposite ends of the spring plate 2 and a lower portion 7 between the upper portions 6. In this embodiment, the spring plate 2 includes bends between the upper and lower portions 6, 7 which defines a U-shape or channel-shape and provides an elastic connection between the upper and lower portions 6, 7, enabling the spring plate 2 to provide a resilient bias on the cap 3 (upwardly) and the heat sink 8 (downwardly). The upper portions 6 may be located in an upper plane that is positioned above a lower plane in which the lower portion 7 is located. As can be seen in FIG. 3, the upper portions 6 of the spring plate 2 may be received into locating grooves or slots in the cavity 4 which may help properly locate the spring plate 2 relative to the cap 3 as well as the heat sink 8. The lower portion 7 of the spring plate 2 may span across and contact a plurality of fins of the heat sink 8, e.g., providing a conductive path for heat transfer. The spring plate 2 may be formed by stamping of a sheet material or other suitable process.

Forming the spring plate 2 of a metal material, such as stainless steel may provide several advantages. For example, where the cap 3 is made of a copper material, the stainless steel spring plate 2 may reduce or avoid electrochemical corrosion after long-term contact with the copper material, improving the stability of the heat exchanger 10. Alternately, or in addition, the spring plate 2 may allow for high temperature joining operations to attach the cap 3 and base 1 together, such as vacuum brazing, welding or other high heat processes. This is in contrast to use of a rubber or other material in the gap between the heat sink 8 and cap 3 which cannot tolerate relatively high temperatures, e.g., of 500 degrees C or more, over relatively long periods, e.g., of an hour or more. Also, in some embodiments, the spring plate 2 may suitably fill the gap between the top surface of the heat sink 8 and the cap 3 so that the spring plate 2 is attached to the heat sink 8 and the cap 3 during a vacuum brazing or other similar attachment process. That is, the spring plate 2 may provide a suitable filler in the gap between the heat sink 8 and the cap 3 so that a brazing filler material will flow into the gap to join the cap 3, spring plate 2 and heat sink 8 top surface together during a vacuum brazing process. This may further aid in thermal conduction between the cap 3 and the heat sink 8.

## Claims

1. A liquid cold plate heat exchanger (10), comprising:
a base (1) having an upper surface (9);
a heat sink (8) having a plurality of fins arranged on the upper surface (9) of the base (1), the plurality of fins defining a top surface of the heat sink (8);
a cap (3) having a lower surface (5) positioned over the upper surface (9) of the base (1) and the heat sink (8); and
a spring plate (2) positioned between the top surface of the heat sink (8) and the lower 10 surface (5) of the cap (3),
wherein with the cap (3) secured to the base (1), there is a gap between the top surface of the heat sink (8) defined by the plurality of fins and the lower surface (5) of the cap (3), the spring plate is arranged in the gap to exert an upward bias on the lower surface (5) of the cap (3) and a downward bias on the top surface of the heat sink (8), and
**characterised in that** the spring plate (2) spans across the plurality of the fins and has a thickness that closely approximates a height of the gap.

2. The liquid cold plate heat exchanger of claim 1, wherein the base, heat sink, cap and spring plate are arranged to withstand a temperature of 500 degrees C for at least 1 hour, preferably arranged to withstand temperatures required to secure the lower surface of the cap to the upper surface of the base by vacuum brazing.

3. The liquid cold plate heat exchanger (10) of one of the preceding claims, wherein the spring plate includes a heat sink (8) contacting portion that contacts the heat sink (8) top surface and a cap (3) contacting portion that contacts the lower surface (5) of the cap (3), and wherein the heat sink (8) contacting portion is between first and second cap (3) contacting portions located at opposite ends of the spring plate.

4. The liquid cold plate heat exchanger (10) of one or the preceding claims, wherein the spring plate is formed of a bent metal sheet that forms the heat sink (8) contacting portion and the first and second cap (3) contacting portions, and wherein the heat sink (8) contacting portion is located in a lower plane positioned below an upper plane in which the first and second cap (3) contacting portions are located.

5. The liquid cold plate heat exchanger (10) of one or the preceding claims, wherein the spring plate is formed of a metal sheet having a thickness of 0.1 to 0.2 mm.

6. The liquid cold plate heat exchanger (10) of one or the preceding claims, wherein the spring plate is formed from a stainless steel metal sheet.

7. The liquid cold plate heat exchanger (10) of one or the preceding claims, wherein the spring plate is formed by stamping a metal sheet material, and where in the stamped spring plate is elastic.

8. The liquid cold plate heat exchanger (10) of one or the preceding claims, wherein the plurality of fins includes fins having a space of 0.1 to 0.2 mm between adjacent fins.

9. The liquid cold plate heat exchanger of claim 1, wherein a portion of the upper surface of the base and a portion of the lower surface of the cap are secured together to form a liquid-tight seal around the heat sink.

10. The liquid cold plate heat exchanger (10) of one of the preceding claims, wherein the cap (3) includes a cavity (4) in a portion of the lower surface (5) arranged to receive and contact the spring plate and to receive at least a portion of the heat sink (8).

11. The liquid cold plate heat exchanger (10) of claim 10, wherein the spring plate includes an upper portion that contacts the cap (3) in the cavity (4), and includes a lower portion that contacts the top surface of the heat sink (8).

12. The liquid cold plate heat exchanger (10) of one of the preceding claims, wherein the height of the gap between lower surface (5) of the cap (3) in the cavity (4) and the top surface of the heat sink (8) is between 0.1mm and 0.2mm.

13. The liquid cold plate heat exchanger (10) of claim 1, wherein the cap (3) has a cavity (4) formed in a portion of the lower surface, the cavity positioned over the upper surface of the base and the heat sink; and
wherein the spring plate is positioned between the top surface of the heat sink and the lower surface of the cap at the cavity, and
wherein a portion of the lower surface (5) of the cap (3) around the cavity (4) is secured to a portion of the upper surface (9) of the base (1) around the heat sink (8), and the spring plate is arranged to exert an upward bias on the lower surface (5) of the cap (3) at the cavity (4) and a downward bias on the top surface of the heat sink (8).

14. The liquid cold plate heat exchanger (10) of claim 13, wherein the portion of the upper surface (9) of the base (1) and the portion of the lower surface (5) of the cap (3) are secured together by vacuum brazing.

15. The liquid cold plate heat exchanger (10) of claim 13 or 14, wherein the spring plate is deformed elastically and/or plastically with contact with the cap (3) and heat sink (8).

## Patentansprüche

1. Flüssigkeitskühlplattenwärmetauscher (10), der umfasst:
eine Basis (1), die eine obere Oberfläche (9) aufweist;
einen Kühlkörper (8), der eine Vielzahl von Rippen aufweist, die auf der oberen Oberfläche (9) der Basis (1) eingerichtet sind, wobei die Vielzahl von Rippen eine obere Oberfläche des Kühlkörpers (8) definiert;
einen Deckel (3), der eine untere Oberfläche (5) aufweist, die über der oberen Oberfläche (9) der Basis (1) und dem Kühlkörper (8) positioniert ist; und
eine Federplatte (2), der zwischen der oberen Oberfläche des Kühlkörpers (8) und der unteren 10 Oberfläche (5) des Deckels (3) positioniert ist,
wobei mit dem Deckel (3), der an der Basis (1) befestigt ist, ein Spalt zwischen der oberen Oberfläche des Kühlkörpers (8) besteht, der von der Vielzahl von Rippen und der unteren Oberfläche (5) des Deckels (3) definiert ist, wobei die Federplatte in dem Spalt eingerichtet ist, um eine Aufwärtsvorspannung auf der unteren Oberfläche (5) des Deckels (3) und eine Abwärtsvorspannung auf der oberen Oberfläche des Kühlkörpers (8) auszuüben, und
**dadurch gekennzeichnet, dass**
die Federplatte (2) die Vielzahl von Rippen überspannt und eine Dicke aufweist, die einer Höhe des Spalts am nächsten kommt.

2. Flüssigkeitskühlplattenwärmetauscher nach Anspruch 1, wobei die Basis, Kühlkörper, Deckel und Federplatte eingerichtet sind, um einer Temperatur von 500 Grad C mindestens 1 Stunde lang standzuhalten, vorzugsweise eingerichtet sind, um Temperaturen standzuhalten, die erforderlich sind, um die untere Oberfläche des Deckels an der oberen Oberfläche der Basis durch Vakuumlöten zu befestigen.

3. Flüssigkeitskühlplattenwärmetauscher (10) nach einem der vorstehenden Ansprüche, wobei die Federplatte einen den Kühlkörper (8) berührenden Abschnitt, der die obere Oberfläche des Kühlkörpers (8) berührt, und einen den Deckel (3) berührenden Abschnitt, der die untere Oberfläche (5) des Deckels (3) berührt, beinhaltet, und wobei der den Kühlkörper (8) berührende Abschnitt zwischen dem ersten und dem zweiten den Deckel (3) berührenden Abschnitt, die sich an entgegengesetzten Enden der Federplatte befinden, liegt.

4. Flüssigkeitskühlplattenwärmetauscher (10) nach einem oder die vorstehenden Ansprüche, wobei die Federplatte aus einem gebogenen Blech gebildet ist, das den den Kühlkörper (8) berührenden Abschnitt und den den Deckel (3) berührenden ersten und zweiten Abschnitt bildet, und wobei der den Kühlkörper (8) berührenden Abschnitt in einer unteren Ebene liegt, die zwischen einer oberen Ebene, in der der erste und der zweite den Deckel (3) berührende Abschnitt liegen, positioniert ist.

5. Flüssigkeitskühlplattenwärmetauscher (10) nach einem der vorstehenden Ansprüche, wobei die Federplatte aus einem Blech, das eine Dicke von 0,1 bis 0,2 mm aufweist, gebildet ist.

6. Flüssigkeitskühlplattenwärmetauscher (10) nach einem der vorstehenden Ansprüche, wobei die Federplatte aus einem rostfreien Stahlblech gebildet ist.

7. Flüssigkeitskühlplattenwärmetauscher (10) nach einem der vorstehenden Ansprüche, wobei die Federplatte durch Stanzen eines Blechmaterials gebildet ist, und wobei die gestanzte Federplatte elastisch ist.

8. Flüssigkeitskühlplattenwärmetauscher (10) nach einem der vorstehenden Ansprüche, wobei die Vielzahl von Rippen Rippen beinhaltet, die einen Raum von 0,1 bis 0,2 mm zwischen benachbarten Rippen aufweisen.

9. Flüssigkeitskühlplattenwärmetauscher nach Anspruch 1, wobei ein Abschnitt der oberen Oberfläche der Basis und ein Abschnitt der unteren Oberfläche des Deckels aneinander befestigt sind, um eine flüssigkeitsdichte Dichtung um den Kühlkörper zu bilden.

10. Flüssigkeitskühlplattenwärmetauscher (10) nach einem der vorstehenden Ansprüche, wobei der Deckel (3) einen Hohlraum (4) in einem Abschnitt der unteren Oberfläche (5) beinhaltet, der eingerichtet ist, um die Federplatte aufzunehmen und zu berühren und mindestens einen Abschnitt des Kühlkörpers (8) aufzunehmen.

11. Flüssigkeitskühlplattenwärmetauscher (10) nach Anspruch 10, wobei die Federplatte einen oberen Abschnitt beinhaltet, der den Deckel (3) in dem Hohlraum (4) berührt, und einen unteren Abschnitt beinhaltet, der die obere Oberfläche des Kühlkörpers (8) berührt.

12. Flüssigkeitskühlplattenwärmetauscher (10) nach einem der vorstehenden Ansprüche, wobei die Höhe des Spalts zwischen der unteren Oberfläche (5) des Deckels (3) in dem Hohlraum (4) und der oberen Oberfläche des Kühlkörpers (8) zwischen 0,1 mm und 0,2 mm beträgt.

13. Flüssigkeitskühlplattenwärmetauscher (10) nach Anspruch 1, wobei der Deckel (3) einen Hohlraum (4) aufweist, der in einem Abschnitt der unteren Oberfläche gebildet ist, wobei der Hohlraum über der oberen Oberfläche der Basis und dem Kühlkörper positioniert ist; und
wobei die Federplatte zwischen der oberen Oberfläche des Kühlkörpers und der unteren Oberfläche des Deckels an dem Hohlraum positioniert ist, und
wobei ein Abschnitt der unteren Oberfläche (5) des Deckels (3) um den Hohlraum (4) an einem Abschnitt der oberen Oberfläche (9) der Basis (1) um den Kühlkörper (8) befestigt ist, und die Federplatte eingerichtet ist, um eine Aufwärtsvorspannung auf der unteren Oberfläche (5) des Deckels (3) an dem Hohlraum (4) und eine Abwärtsvorspannung auf der oberen Oberfläche des Kühlkörpers (8) auszuüben.

14. Flüssigkeitskühlplattenwärmetauscher (10) nach Anspruch 13, wobei der Abschnitt der oberen Oberfläche (9) der Basis (1) und der Abschnitt der unteren Oberfläche (5) des Deckels (3) aneinander durch Vakuumlöten befestigt sind.

15. Flüssigkeitskühlplattenwärmetauscher (10) nach Anspruch 13 oder 14, wobei die Federplatte elastisch und/oder plastisch mit Berührung mit dem Deckel (3) und dem Kühlkörper (8) verformt ist.

## Revendications

1. Echangeur thermique à plaque froide à liquide (10), comprenant :
une base (1) présentant une surface supérieure (9) ;
un dissipateur thermique (8) présentant une pluralité d'ailettes agencées sur la surface supérieure (9) de la base (1), la pluralité d'ailettes définissant une surface supérieure du dissipateur thermique (8) ;
un couvercle (3) présentant une surface inférieure (5) positionnée sur la surface supérieure (9) de la base (1) et du dissipateur thermique (8) ; et
une plaque-ressort (2) positionnée entre la surface supérieure du dissipateur thermique (8) et la surface inférieure (5) 10 du couvercle (3),
dans lequel avec le couvercle (3) fixé sur la base (1), il existe un espace entre la surface supérieure du dissipateur thermique (8) définie par la pluralité d'ailettes et la surface inférieure (5) du couvercle (3), la plaque-ressort est agencée dans l'espace pour exercer une sollicitation vers le haut sur la surface inférieure (5) du couvercle (3) et une sollicitation vers le bas sur la surface supérieure du dissipateur thermique (8), et
**caractérisé en ce que**
la plaque-ressort (2) s'étend le long de la pluralité des ailettes et présente une épaisseur qui s'approche étroitement d'une hauteur du couvercle.

2. Echangeur thermique à plaque froide à liquide selon la revendication 1, dans lequel la base, le dissipateur thermique, le couvercle et la plaque-ressort sont conçus pour résister à une température de 500 degrés C pendant au moins 1 heure, de préférence conçus pour résister à des températures requises pour fixer la surface inférieure du couvercle sur la surface supérieure de la base par brasage fort sous vide.

3. Echangeur thermique à plaque froide à liquide (10) selon l'une des revendications précédentes, dans lequel la plaque-ressort inclut une partie en contact avec le dissipateur thermique (8) qui est en contact avec la surface supérieure du dissipateur thermique (8) et une partie en contact avec le couvercle (3) qui est en contact avec la surface inférieure (5) du couvercle (3), et dans lequel la partie en contact avec le dissipateur thermique (8) se trouve entre des première et secondes parties en contact avec le couvercle (3) situées au niveau d'extrémités opposées de la plaque-ressort.

4. Echangeur thermique à plaque froide à liquide (10) selon l'une ou les revendications précédentes, dans lequel la plaque-ressort est formée d'une feuille métallique cintrée qui forme la partie en contact avec le dissipateur thermique (8) et les première et seconde parties en contact avec le couvercle (3), et dans lequel la partie en contact avec le dissipateur thermique (8) est située dans un plan inférieur positionné en dessous d'un plan supérieur dans lequel sont situées les première et seconde parties en contact avec le couvercle (3).

5. Echangeur thermique à plaque froide à liquide (10) selon l'une ou les revendications précédentes, dans lequel la plaque-ressort est formée d'une feuille métallique présentant une épaisseur de 0,1 à 0,2 mm.

6. Echangeur thermique à plaque froide à liquide (10) selon l'une ou les revendications précédentes, dans lequel la plaque-ressort est formée à partir d'une feuille métallique en acier inoxydable.

7. Echangeur thermique à plaque froide à liquide (10) selon l'une ou les revendications précédentes, dans lequel la plaque-ressort est formée par estampage d'un matériau de feuille métallique, et où la plaque-ressort estampée est élastique.

8. Echangeur thermique à plaque froide à liquide (10) selon l'une ou les revendications précédentes, dans lequel la pluralité d'ailettes inclut des ailettes présentant un espace de 0,1 à 0,2 mm entre des ailettes adjacentes.

9. Echangeur thermique à plaque froide à liquide selon la revendication 1, dans lequel une partie de la surface supérieure de la base et une partie de la surface inférieure du couvercle sont fixées l'une à l'autre pour former un joint étanche au liquide autour du dissipateur thermique.

10. Echangeur thermique à plaque froide à liquide (10) selon l'une des revendications précédentes, dans lequel le couvercle (3) inclut une cavité (4) dans une partie de la surface inférieure (5) conçue pour recevoir et être en contact avec la plaque-ressort et pour recevoir au moins une partie du dissipateur thermique (8).

11. Echangeur thermique à plaque froide à liquide (10) selon la revendication 10, dans lequel la plaque-ressort inclut une partie supérieure qui est en contact avec le couvercle (3) dans la cavité (4), et inclut une partie inférieure qui est en contact avec la surface supérieure du dissipateur thermique (8).

12. Echangeur thermique à plaque froide à liquide (10) selon l'une des revendications précédentes, dans lequel la hauteur de l'espace entre la surface inférieure (5) du couvercle (3) dans la cavité (4) et la surface supérieure du dissipateur thermique (8) est comprise entre 0,1 mm et 0,2 mm.

13. Echangeur thermique à plaque froide à liquide (10) selon la revendication 1, dans lequel le couvercle (3) présente une cavité (4) formée dans une partie de la surface inférieure, la cavité étant positionnée sur la surface supérieure de la base et du dissipateur thermique ; et
dans lequel la plaque-ressort est positionnée entre la surface supérieure du dissipateur thermique et la surface inférieure du couvercle au niveau de la cavité, et
dans lequel une partie de la surface inférieure (5) du couvercle (3) autour de la cavité (4) est fixée à une partie de la surface supérieure (9) de la base (1) autour du dissipateur thermique (8), et la plaque-ressort est conçue pour exercer une sollicitation vers le haut sur la surface inférieure (5) du couvercle (3) au niveau de la cavité (4) et une sollicitation vers le bas sur la surface supérieure du dissipateur thermique (8).

14. Echangeur thermique à plaque froide à liquide (10) selon la revendication 13, dans lequel la partie de la surface supérieure (9) de la base (1) et la partie de la surface inférieure (5) du couvercle (3) sont fixées l'une à l'autre par brasage fort sous vide.

15. Echangeur thermique à plaque froide à liquide (10) selon la revendication 13 ou 14, dans lequel la plaque-ressort est déformée élastiquement et/ou plastiquement au contact avec le couvercle (3) et le dissipateur thermique (8).
